# EUROPEAN PATENT APPLICATION

(11) **EP 4 723 490 A1**
(43) Date of publication of application: **08.04.2026**
(21) Application number: 25819051.1
(22) Date of filing: 29.05.2025
(51) Int. Cl.: H04B 1/40

(54) **RADIO FREQUENCY FRONT-END MODULE AND RADIO FREQUENCY CHIP**

(30) Priority: 05.06.2024 CN 202410722214
(71) Applicant: Lansus Technologies Inc., Shenzhen, Guangdong 518052 (CN)
(72) Inventor: SHAO, Yixiang, Shenzhen, Guangdong 518052 (CN); GUO, Jiashuai, Shenzhen, Guangdong 518052 (CN)
(74) Representative: Metida
(86) International application number: PCT/CN2025/098038
(87) International publication number: WO 2025/251998

(57) **Abstract**

A radio frequency (RF) front-end module and an RF chip are provided. The RF front-end module includes a signal input end, an input matching circuit, an amplification circuit, an output matching circuit, a signal output end, and a bias circuit. A first end of the bias circuit is configured to be connected to a power supply, a second end of the bias circuit is configured to be connected to an external logic control circuit, and a third end of the bias circuit is configured to output a bias current to an input end of the amplification circuit. The external logic control circuit is configured to control on/off of the amplification circuit. The bias circuit includes a current mirror circuit, a first triode, a second triode, a third triode, a first resistor, a second resistor, and a third resistor. IIP3 performance of the RF front-end module is excellent.

## Description

### TECHNICAL FIELD

The present disclosure relates to a field of wireless communication technology, and in particular to a radio frequency front-end module and a radio frequency chip.

### BACKGROUND

Mobile communication terminals have become increasingly prevalent in modern society for wireless communication. The ever-growing processing power of the mobile communication terminal has led to their evolution into mobile multimedia centers. Currently, there are two main technological approaches in mobile communication, which are respectively cellular mobile communication and Wi-Fi. The two technological approaches are still evolving, sharing common characteristics of large communication bandwidth and high transmission rates to meet ever-growing needs of users. In mobile communication terminals, radio frequency (RF) signals are amplified by a power amplifier and transmitted through an antenna.

With development of communication technology, RF front-ends of mobile phones are a key component for signal transmission and reception in RF transceiver chips. As communication becomes more multi-mode and multi-standard, the RF front-ends are responsible for transmitting and receiving signals of various standards and modes, which places increasing demands on RF amplifiers in the RF front-ends, such as higher frequencies, larger bandwidths, higher linearity, and wider operating voltage ranges. For example, in Wi-Fi systems, the RF amplifiers in access points (APs)/routers commonly operate at around 5V, while the RF amplifiers in station devices (such as the mobile phones and tablets) commonly operate at around 3.3V.

However, conventional RF amplifiers are only able to operate within a narrow voltage range, making them unsuitable for use in different devices. RF amplifier suppliers generally need to develop different RF amplifiers for different operating voltages, increasing development costs and timelines.

### SUMMARY

A purpose of the present disclosure is to provide a radio frequency (RF) front-end module that outputs high and low levels through a bias circuit, thereby solving problems of poor operating voltage regulation, high cost, and limited applicability of conventional RF front-end modules.

To achieve the above purpose, the present disclosure provides the RF front-end module. The RF front-end module comprises a signal input end, an input matching circuit, an amplification circuit, an output matching circuit, a signal output end, and a bias circuit.

The signal input end, the input matching circuit, the amplification circuit, the output matching circuit, and the signal output end are electrically connected in sequence. A first end of the bias circuit is configured to be connected to a power supply, a second end of the bias circuit is configured to be connected to an external logic control circuit, and a third end of the bias circuit is configured to output a bias current to an input end of the amplification circuit. The external logic control circuit is configured to control on/off of the amplification circuit. The bias circuit comprises a current mirror circuit, a first triode, a second triode, a third triode, a first resistor, a second resistor, and a third resistor.

A base of the first triode is configured as the second end of the bias circuit, an emitter of the first triode is grounded, and a collector of the first triode is connected to a first end of the second resistor and a first end of the third resistor. The second end of the second resistor is configured as the first end of the bias circuit and is connected to a first end of the first resistor. A second end of the first resistor is connected to an emitter of the second triode. A second end of the third resistor is connected to a base of the second triode. A collector of the second triode is connected to a collector of the third triode.

The collector of the third triode is further connected to a base of the third triode, an emitter of the third triode is connected to an input end of the current mirror circuit, and an output end of the current mirror circuit is configured as the third end of the bias circuit.

In one optional embodiment, the RF front-end module further comprises a fourth resistor, and the base of the first triode is connected to the external logic control circuit after being connected in series with the fourth resistor.

In one optional embodiment, the current mirror circuit comprises a current mirror unit and a voltage adjustment unit.

A first end of the voltage adjustment unit is configured as the input end of the current mirror circuit, a second end of the voltage adjustment unit is configured to be connected to an external linear voltage stabilizing source, and a third end of the voltage adjustment unit is connected to an input end of the current mirror unit. An output end of the current mirror unit is configured as the output end of the current mirror circuit. The voltage adjustment unit is configured to adjust a bias voltage output by the third triode, and the current mirror unit is configured to convert the bias voltage into a corresponding bias current for output.

In one optional embodiment, the voltage adjustment unit comprises a fourth triode, a fifth resistor and a sixth resistor. A base of the fourth triode is configured as the first end of the voltage adjustment unit, a collector of the fourth triode is configured as the second end of the voltage adjustment unit and is connected to a first end of the fifth resistor, and an emitter of the fourth triode is connected to a first end of the sixth resistor. A second end of the sixth resistor is configured as the third end of the voltage adjustment unit and is connected to a second end of the fifth resistor.

In one optional embodiment, the current mirror unit comprises a fifth triode, a sixth triode, a seventh triode and a seventh resistor. A collector of the fifth triode is configured as the input end of the current mirror unit, the collector of the fifth triode is further connected to a base of the fifth triode and a base of the seventh triode, an emitter of the fifth triode is connected to a collector of the sixth triode and a base of the sixth triode, and an emitter of the sixth triode is grounded. A collector of the seventh triode is connected to a first end of the seventh resistor, a second end of the seventh resistor is connected to the first end of the fifth resistor, and an emitter of the seventh triode is configured as the output end of the current mirror unit.

In one optional embodiment, the amplification circuit is an eighth triode. A base of the eighth triode is configured as the input end of the amplification circuit, a collector of the eighth triode is configured as an output end of the amplification circuit, and an emitter of the eighth triode is grounded.

In one optional embodiment, the RF front-end module further comprises a first inductor. A first end of the first inductor is connected to an output end of the amplification circuit, and a second end of the first inductor is configured to be connected to the power supply.

In one optional embodiment, the RF front-end module further comprises a ninth triode. A collector of the ninth triode is connected to the collector of the second triode and a base of the ninth triode, and an emitter of the ninth triode is connected to the collector of the third triode.

In one optional embodiment, the first triode is an NPN triode, and the second triode is a PNP triode.

The present disclosure further provides an RF chip. The RF chip comprises the RF front-end module described above.

Compared with the prior art, in the present disclosure, the RF front-end module comprises the bias circuit. The first end of the bias circuit is configured to be connected to the power supply, the second end of the bias circuit is configured to be connected to the external logic control circuit, and the third end of the bias circuit is configured to output the bias current to an input end of the amplification circuit. The external logic control circuit is configured to control on/off of the amplification circuit. In this way, the bias circuit is enabled to adaptively operate at different voltages without external interference; thereby reducing energy consumption, saving costs, and extending service life.

### BRIEF DESCRIPTION OF DRAWINGS

In order to clearly describe technical solutions in the embodiments of the present disclosure, the following will briefly introduce the drawings that need to be used in the description of the embodiments or the prior art. Apparently, the drawings in the following description are merely some of the embodiments of the present disclosure, and those skilled in the art are able to obtain other drawings according to the drawings without contributing any inventive labor.
FIG. 1 is a circuit diagram of an RF front-end module according to one embodiment of the present disclosure.
FIG. 2 is a schematic diagram of a V/I curve when a sixth resistor is 1000 ohms according to one embodiment of the present disclosure.
FIG. 3 is a schematic diagram of a V/I curve when the sixth resistor is 600 ohms according to one embodiment of the present disclosure.

In the drawings: 100-RF front-end module, 1-signal input end, 2-input matching circuit, 3-amplification circuit, 4-output matching circuit, 5-signal output end, 6-bias circuit, 61-current mirror circuit, 611-current mirror unit, 612-voltage adjustment unit.

### DETAILED DESCRIPTION

Technical solutions in the embodiments of the present disclosure will be clearly and completely described below in conjunction with the accompanying drawings in the embodiments of the present disclosure. Obviously, the described embodiments are only a part of the embodiments of the present disclosure, rather than all of the embodiments. Based on the embodiments of the present disclosure, all other embodiments obtained by those of ordinary skill in the art without creative work shall fall within the protection scope of the present disclosure.

### Embodiment 1

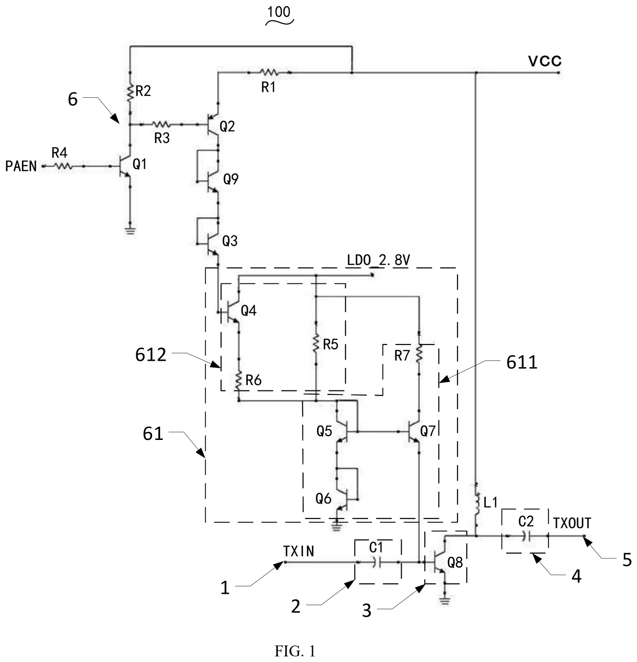

As shown in FIGS. 1-3, the present disclosure provides an RF front-end module 100. The RF front-end module 100 comprises a signal input end 1, an input matching circuit 2, an amplification circuit 3, an output matching circuit 4, a signal output end 5, and a bias circuit 6.

The signal input end 1, the input matching circuit 2, the amplification circuit 3, the output matching circuit 4, and the signal output end 5 are electrically connected in sequence. A first end of the bias circuit 6 is configured to be connected to a power supply, a second end of the bias circuit 6 is configured to be connected to an external logic control circuit, and a third end of the bias circuit 6 is configured to output a bias current to an input end of the amplification circuit 3. The external logic control circuit is configured to control on/off of the amplification circuit 3.

When the external logic control circuit outputs a high-level signal, the amplification circuit 3 is turned on. When the external logic control circuit outputs a low-level signal, the amplification circuit 3 is turned off. Alternatively, the amplification circuit 3 is turned off when the external logic control circuit outputs the high-level signal and is turned on when the external logic control circuit outputs the low-level signal.

In the embodiment, the input matching circuit 2 is a first capacitor C1, and the output matching circuit 4 is a second capacitor C2.

The bias circuit 6 comprises a current mirror circuit 61, a first triode Q1, a second triode Q2, a third triode Q3, a first resistor R1, a second resistor R2, and a third resistor R3. A base of the first triode Q1 is configured as the second end of the bias circuit 6, an emitter of the first triode Q1 is grounded, and a collector of the first triode Q1 is connected to a first end of the second resistor R2 and a first end of the third resistor R3. The second end of the second resistor R2 is configured as the first end of the bias circuit 6 and is connected to a first end of the first resistor R1. A second end of the first resistor R1 is connected to an emitter of the second triode Q2. A second end of the third resistor R3 is connected to a base of the second triode Q2. A collector of the second triode Q2 is connected to a collector of the third triode Q3. The collector of the third triode Q3 is further connected to a base of the third triode Q3, an emitter of the third triode Q3 is connected to an input end of the current mirror circuit 61, and an output end of the current mirror circuit 61 is configured as the third end of the bias circuit 6.

In the embodiment, the first triode Q1 is an NPN triode, and the second triode Q2 is a PNP triode. Specifically, the first triode Q1 is connected to the power supply through the second resistor R2, and the second triode Q2 is connected to the power supply through the first resistor R1. The power supply meets a certain voltage range, such as 3.5V-5V. Moreover, the first resistor R1 and the second resistor R2 provide stable power supplies for the second triode Q2 and the third triode Q3, respectively.

The collector and the base of the third triode Q3 are connected together to form a diode. More third triodes Q3 may be increased according to a required voltage range of the power supply; which is not described further herein.

The external logic control circuit outputs the high-level signal to turn on the first triode Q1, causing the collector of the first triode Q1 to output a low-level signal, which in turn turns on the second triode Q2. The collector of the second triode Q2 outputs the bias current to the third triode Q3, and the emitter of the third triode Q3 outputs the bias current to the current mirror circuit 61. The current mirror circuit 61 then outputs an adjusted bias current to the input end of the amplification circuit 3, thus enabling the amplification circuit 3 to be turned on or off. When the external logic control circuit outputs the high-level signal, the amplification circuit 3 is on. When the external logic control circuit outputs the low-level signal, the amplification circuit 3 is off. In this way, the bias circuit 6 is enabled to adaptively operate at different voltages without external interference, thereby reducing energy consumption and extending product lifespan.

In the embodiment, the RF front-end module 100 further comprises a fourth resistor R4, and the base of the first triode Q1 is connected to the external logic control circuit after being connected in series with the fourth resistor R4. The fourth resistor R4 is configured to adjust the stability of an output control signal of the external logic control circuit, ensuring a safe operation of the first triode Q1.

In one optional embodiment, the current mirror circuit 61 comprises a current mirror unit 611 and a voltage adjustment unit 612. A first end of the voltage adjustment unit 612 is configured as the input end of the current mirror circuit 61, a second end of the voltage adjustment unit 612 is configured to be connected to an external linear voltage stabilizing source (LDO), and a third end of the voltage adjustment unit 612 is connected to an input end of the current mirror unit 611. An output end of the current mirror unit 611 is configured as the output end of the current mirror circuit 61. The voltage adjustment unit 612 is configured to adjust a bias voltage output by the third triode Q3, and the current mirror unit 611 is configured to convert the bias voltage into a corresponding bias current for output.

The voltage adjustment unit 612 is configured to regulate the bias current output of the third transistor Q3, keeping the bias current within a control range under different voltages, resulting in good voltage range control. Furthermore, the current mirror circuit 61 converts the bias voltage output from the voltage adjustment unit 612 into the corresponding bias current, thereby effectively controlling the on/off of the amplification circuit 3.

In the embodiment, the voltage adjustment unit 612 comprises a fourth triode Q4, a fifth resistor R5 and a sixth resistor R6.

A base of the fourth triode Q4 is configured as the first end of the voltage adjustment unit 612, a collector of the fourth triode Q4 is configured as the second end of the voltage adjustment unit 612 and is connected to a first end of the fifth resistor R5, and an emitter of the fourth triode Q4 is connected to a first end of the sixth resistor R6. A second end of the sixth resistor R6 is configured as the third end of the voltage adjustment unit 612 and is connected to a second end of the fifth resistor R5.

In the embodiment, the current mirror unit 611 comprises a fifth triode Q5 a sixth triode Q6, a seventh triode Q7 and a seventh resistor R7. A collector of the fifth triode is configured as the input end of the current mirror unit 611, the collector of the fifth triode is further connected to a base of the fifth triode and a base of the seventh triode Q7, an emitter of the fifth triode is connected to a collector of the sixth triode Q6 and a base of the sixth triode Q6, and an emitter of the sixth triode Q6 is grounded. A collector of the seventh triode Q7 is connected to a first end of the seventh resistor R7, a second end of the seventh resistor R7 is connected to the first end of the fifth resistor R5, and an emitter of the seventh triode Q7 is configured as the output end of the current mirror unit 611.

In the embodiment, the amplification circuit 3 is an eighth triode Q8. A base of the eighth triode Q8 is configured as the input end of the amplification circuit 3, a collector of the eighth triode Q8 is configured as an output end of the amplification circuit 3, and an emitter of the eighth triode Q8 is grounded.

Optionally, the amplification circuit 3 is a bipolar transistor or a field-effect transistor. The amplification circuit 3 is configured to amplify RF signals. A small RF signal enters the base of the eighth triode Q8 through the first capacitor C1; then an amplified RF signal is output through the second capacitor C2.

In the embodiment, the RF front-end module 100 further comprises a first inductor L1. A first end of the first inductor L1 is connected to an output end of the amplification circuit 3, and a second end of the first inductor L1 is configured to be connected to the power supply.

In the embodiment, the RF front-end module 100 further comprises a ninth triode Q9. A collector of the ninth triode Q9 is connected to the collector of the second triode Q2 and a base of the ninth triode Q9, and an emitter of the ninth triode Q9 is connected to the collector of the third triode Q3.

In practical implementation, the emitter of the third triode Q3 outputs the current to control an operating state of the fourth triode Q4.

LDO Out is controlled by a power amplifier enable signal (PAEN signal) output from the external logic control circuit. When the PAEN signal is at a high level, LDO_Out outputs a direct current (DC) voltage, such as 2.8V; otherwise, LDO_Out outputs the DC voltage of 0V.

When the PAEN signal is at a low level, LDO_2.8V = 0V. At this time, the collector of the third triode Q3 does not output the bias current, and the eighth triode Q8 does not operate.

When the PAEN signal is at the high level, and VCC < LowLimitV, such as LowLimitV = 3.6 V, the base of the fourth triode Q4 is unable to receive a sufficient driving current under a voltage drop of a PN junction of the third triode 3, the ninth triode Q9, the fifth triode Q5, and the sixth triode Q6, resulting in that the collector and the emitter of the fourth triode Q4 are unable to be turned on. Therefore, R ' = R5

When the PAEN signal is at the high level and VCC > LowLimitV, such as LowLLimitV = 3.6 V, a current at the base of the fourth triode Q4 increases, a resistance between the collector and the emitter of the fourth triode Q4 decreases, and R ' is reduced accordingly. Under an action of a current mirror of the fifth triode Q5, the sixth triode Q6, and the seventh triode Q7, the bias current output by the emitter of the seventh triode Q7 gradually increases, and an operating state of the eighth triode Q8 changes accordingly.

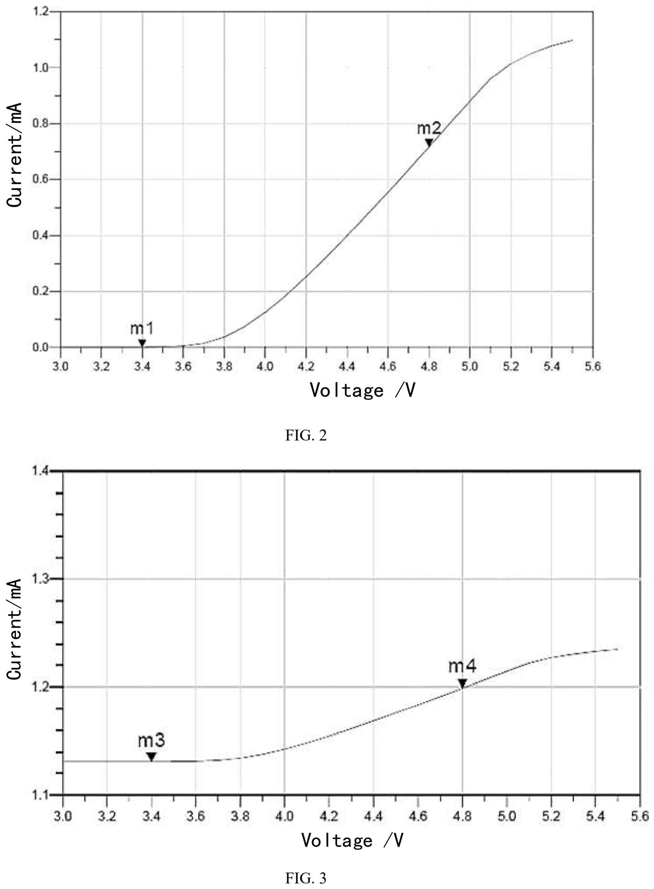

Therefore, when the VCC changes from a low voltage to a high voltage, the change in the bias current at the base of the eighth triode Q 8 is shown in FIG. 2.

In order to increase flexibility of circuit design, a control range under different voltages is adjusted by changing a resistance value of the sixth resistor R6. The sixth resistor R6 is taken as an example of 1000 ohms and 500 ohms, respectively.

When the sixth resistor R6 = 1000 ohms, in a V/I curve shown in FIG. 2, current values of points m1 and m2 are less than 0.8 mA. At this time, the current value is small.

When the sixth resistor R6 = 500 ohms, in a V/I curve shown in FIG. 3, the current values of points m3 and m4 are greater than 1.12 mA. At this time, the current value is large.

### Embodiment 2

The present disclosure further provides an RF chip. The RF chip comprises the RF front-end module 100 described above.

It is noted that in the specification, terms "comprise", "comprise" or any other variation thereof are intended to encompass non-exclusive inclusion, such that a process, method, article or device not only comprises elements explicitly listed, but also comprises elements not explicitly listed or other elements inherent to such a process, method, article or device. An element defined by a sentence "comprises one" does not exclude the presence of additional identical elements in the process, method, article, or apparatus that comprises the element.

The above are only embodiments of the present disclosure, and are not intended to limit the patent scope of the present disclosure. Any equivalent structure or equivalent process transformation made by using the description and drawings of the present disclosure, or directly or indirectly applied to other related technical fields, are all comprised in the protection scope of the present disclosure.

## Claims

1. A radio frequency (RF) front-end module, comprising:
a signal input end;
an input matching circuit;
an amplification circuit;
an output matching circuit;
a signal output end; and
a bias circuit;
wherein the signal input end, the input matching circuit, the amplification circuit, the output matching circuit, and the signal output end are electrically connected in sequence;
wherein a first end of the bias circuit is configured to be connected to a power supply, a second end of the bias circuit is configured to be connected to an external logic control circuit, a third end of the bias circuit is configured to output a bias current to an input end of the amplification circuit, and the external logic control circuit is configured to control on/off of the amplification circuit;
wherein the bias circuit comprises a current mirror circuit, a first triode, a second triode, a third triode, a first resistor, a second resistor, and a third resistor;
wherein a base of the first triode is configured as the second end of the bias circuit, an emitter of the first triode is grounded, and a collector of the first triode is connected to a first end of the second resistor and a first end of the third resistor;
wherein the second end of the second resistor is configured as the first end of the bias circuit and is connected to a first end of the first resistor, a second end of the first resistor is connected to an emitter of the second triode, a second end of the third resistor is connected to a base of the second triode, and a collector of the second triode is connected to a collector of the third triode;
wherein the collector of the third triode is further connected to a base of the third triode, an emitter of the third triode is connected to an input end of the current mirror circuit, and an output end of the current mirror circuit is configured as the third end of the bias circuit.

2. The RF front-end module according to claim **1,** wherein the RF front-end module further comprises a fourth resistor, and the base of the first triode is connected to the external logic control circuit after being connected in series with the fourth resistor.

3. The RF front-end module according to claim 1, wherein the current mirror circuit comprises a current mirror unit and a voltage adjustment unit;
wherein a first end of the voltage adjustment unit is configured as the input end of the current mirror circuit, a second end of the voltage adjustment unit is configured to be connected to an external linear voltage stabilizing source, a third end of the voltage adjustment unit is connected to an input end of the current mirror unit, and an output end of the current mirror unit is configured as the output end of the current mirror circuit;
wherein the voltage adjustment unit is configured to adjust a bias voltage output by the third triode, and the current mirror unit is configured to convert the bias voltage into a corresponding bias current for output.

4. The RF front-end module according to claim 3, wherein the voltage adjustment unit comprises a fourth triode, a fifth resistor and a sixth resistor;
wherein a base of the fourth triode is configured as the first end of the voltage adjustment unit, a collector of the fourth triode is configured as the second end of the voltage adjustment unit and is connected to a first end of the fifth resistor, an emitter of the fourth triode is connected to a first end of the sixth resistor, and a second end of the sixth resistor is configured as the third end of the voltage adjustment unit and is connected to a second end of the fifth resistor.

5. The RF front-end module according to claim 4, wherein the current mirror unit comprises a fifth triode, a sixth triode, a seventh triode and a seventh resistor;
wherein a collector of the fifth triode is configured as the input end of the current mirror unit, the collector of the fifth triode is further connected to a base of the fifth triode and a base of the seventh triode, an emitter of the fifth triode is connected to a collector of the sixth triode and a base of the sixth triode, and an emitter of the sixth triode is grounded;
wherein a collector of the seventh triode is connected to a first end of the seventh resistor, a second end of the seventh resistor is connected to the first end of the fifth resistor, and an emitter of the seventh triode is configured as the output end of the current mirror unit.

6. The RF front-end module according to claim 1, wherein the amplification circuit is an eighth triode;
wherein a base of the eighth triode is configured as the input end of the amplification circuit, a collector of the eighth triode is configured as an output end of the amplification circuit, and an emitter of the eighth triode is grounded.

7. The RF front-end module according to claim 1, wherein the RF front-end module further comprises a first inductor;
wherein a first end of the first inductor is connected to an output end of the amplification circuit, and a second end of the first inductor is configured to be connected to the power supply.

8. The RF front-end module according to claim 1, wherein the RF front-end module further comprises a ninth triode;
wherein a collector of the ninth triode is connected to the collector of the second triode and a base of the ninth triode, and an emitter of the ninth triode is connected to the collector of the third triode.

9. The RF front-end module according to claim 1, wherein the first triode is an NPN triode, and the second triode is a PNP triode.

10. An RF chip, comprising: the RF front-end module according to any one of claims 1-9.
